Europäisches Patentamt

European Patent Office

Office européen des brevets

(11) Numéro de publication: **0 107 592**
**A2**

(12)

# DEMANDE DE BREVET EUROPEEN

(21) Numéro de dépôt: **83402041.4**

(22) Date de dépôt: **21.10.83**

(51) Int. Cl.³: **H 05 K 7/02, H 04 R 1/08**

(30) Priorité: **29.10.82 FR 8218242**

(43) Date de publication de la demande: **02.05.84**
**Bulletin 84/18**

(84) Etats contractants désignés: **DE GB IT NL**

(71) Demandeur: **THOMSON-BRANDT, 173, Boulevard Haussmann, F-75379 Paris Cedex 08 (FR)**

(72) Inventeur: **Pissot, Guy, THOMSON-CSF SCPI 173, bld Haussmann, F-75379 Paris Cedex 08 (FR)**

(74) Mandataire: **Schmolka, Robert et al, THOMSON-CSF SCPI 173, Bld Haussmann, F-75379 Paris Cedex 08 (FR)**

(54) **Appareil utilisant un microphone escamotable.**

(57) La présente invention concerne un appareil utilisant un microphone escamotable.

Le microphone 3, quand il n'est pas utilisé, est rangé dans un étui 8, 2 escamotable installé dans un orifice 7 de l'appareil 1. Le microphone comporte un connecteur arrière 5 qui porte un fil 6 à tores constamment connecté à un connecteur fixe 12 à l'intérieur de l'appareil. L'étui comporte un cabochon 2 en manière de bouton que l'utilisateur peut actionner pour extraire le microphone.

# APPAREIL UTILISANT UN MICROPHONE ESCAMOTABLE

La présente invention concerne un appareil utilisant un microphone escamotable.

Dans l'art antérieur, les microphones utilisés pour les appareils audio-fréquence (magnétophones, amplificateurs, etc...), sont raccordés par des prises enfichables à l'appareil et rangés séparément de l'appareil quand ils ne servent pas. Cette disposition entraîne l'usage d'un connecteur coûteux car il doit être solide puisqu'il est fréquemment utilisé. De plus, le microphone peut être égaré ou stocké dans de mauvaises conditions. Pour remédier à ces inconvénients, la présente invention propose un rangement spécial du microphone à l'intérieur de l'appareil. Le microphone reste constamment connecté aux circuits électriques de l'appareil et il reste toujours attaché à l'appareil. Le connecteur est donc plus simple et le rangement assuré sans risque d'endommagement ni d'égarement.

En effet, la présente invention concerne un appareil utilisant un microphone escamotable dans un orifice pratiqué sur l'une de ses faces et dans lequel le microphone peut être rangé. D'autre part, le fil du microphone est constamment relié à un connecteur interne à l'appareil.

La présente invention sera mieux comprise à l'aide de la description et des figures annexées qui sont :

- la figure 1 : un schéma général d'un appareil selon l'invention, le microphone étant rangé,

- la figure 2 : un schéma du même appareil dans lequel le microphone est en utilisation,

2

- la figure 3 : une partie de la face avant de l'appareil utilisant un étui de rangement de microphone selon l'invention.

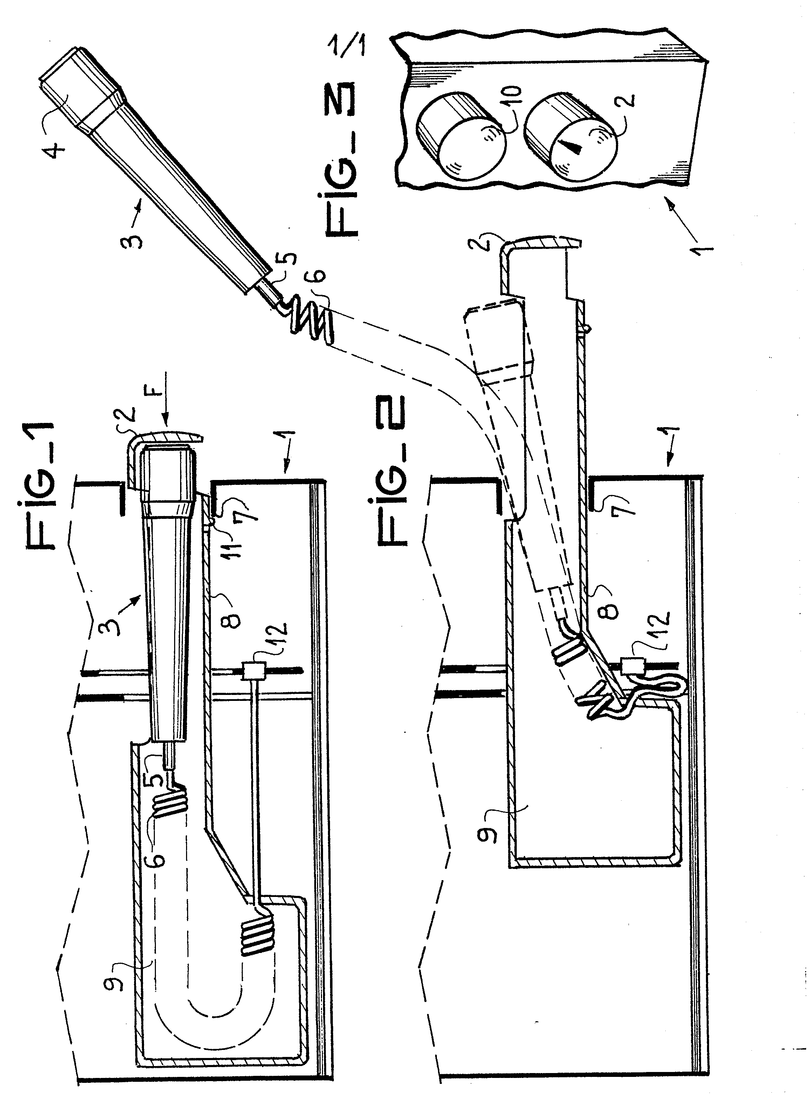

A la figure 1, l'appareil audio-fréquence 1 comporte sur sa face avant un orifice 7 de guide et support à un étui 2, 8 escamotable. Cet étui comporte un cabochon en imitation de bouton 2 et une gouttière 8 vers le bas de l'appareil qui coulisse au cours de l'extraction de l'étui dans l'orifice 7 du châssis de l'appareil. A l'intérieur de cet étui est installé un microphone 3 dont la capsule active 4 est placée à l'intérieur du cabochon 2 et le connecteur 5 arrière est relié d'une façon permanente à un cordon en tores 6. L'autre extrémité du cordon 6 est relié à un connecteur 12 de connection électrique, fixé d'une façon permanente aux circuits de l'appareil. A la position repliée de l'étui, l'ensemble du cordon 6 est installé dans une réserve arrière 9 de fil.

A la figure 2, on a représenté l'appareil dans lequel l'étui a été tiré de façon à permettre l'extraction du microphone de son étui 2,8. Le microphone 3 est en service et peut donc être déplacé comme il est habituel de le faire pour les appareils fixes du type amplificateur, table de mixage ou magnétophone à bande ou à cassette. Pour celà, la gouttière 8 a coulissée à l'intérieur de l'orifice 7 de façon à libérer l'accès au microphone 3. La gouttière 8 peut être munie avantageusement d'un moyen 11 d'encliquetage de l'étui à l'intérieur de l'appareil 1. En effet le cabochon 2 en imitation de bouton doit rester d'une façon permanente en position de la face avant de l'appareil quand l'étui est en position repliée. Quand l'utilisateur désire extraire le microphone de son étui, il exerce une traction sur le bouton par exemple en agissant sur un moyen d'escamotage de l'encliquetage. L'encliquetage s'escamote et le microphone apparaît. L'action de sortie du microphone 3 peut être complété par un moyen moteur comme un ressort comprimé et bloqué quand l'étui est fermé. Le ressort éjecte l'étui quand l'utilisateur efface les moyens d'encliquetage du cabochon 2.

A la figure 3, on a représenté l'aspect que prend la partie de la face avant de l'appareil 1 qui comporte un étui escamotable selon l'invention. Le cabochon 2 se fond harmonieusement dans l'esthétique de l'appareil ce qui est un effet second de l'invention.

D'autres variantes peuvent être réalisées selon l'invention. En particulier, le microphone 3 peut être rangé dans un orifice semblable à l'orifice 7 mais pratiqué sur une face quelconque accessible de l'appareil. Cet orifice peut être fermé par un moyen quelconque escamotable permettant à l'utilisateur de saisir le microphone. L'orifice peut alors ne pas comporter de gouttière supportant le microphone et qui coulisse à l'extraction.

D'autre part, la manoeuvre du cabochon 2, dans une autre variante selon l'invention, permet d'actionner un moyen de mise en circuit des éléments électroniques qui reçoivent les signaux électriques du microphone. Ce moyen comporte notamment un relais ou micro-contact, actionné par l'escamotage de l'encliquetage.

Si l'appareil utilise deux microphones ou plus, l'invention s'applique aussi bien en groupant les microphones dans un même orifice, avec un ou plusieurs étuis amovibles ou encore dans des orifices séparés.

4

## REVENDICATIONS

1. Appareil utilisant au moins un microphone, caractérisé en ce qu'il comporte au moins un orifice (7) dans lequel le microphone (3) correspondant est escamoté hors utilisation et en ce que le microphone (3) est relié en permanence à un connecteur (12) aux circuits électriques internes par un cordon électrique (6).

2. Appareil selon la revendication 1, caractérisé en ce que l'orifice (7) est placé sur une face apparente de l'appareil (1) et qu'un cabochon amovible (2) en imitation de bouton le ferme en position de rangement.

3. Appareil selon la revendication 2, caractérisé en ce que le cabochon (2) est fixé à un étui comportant une gouttière coulissante (8) dans l'orifice (7) destinée à recevoir le microphone (3) tout en permettant son extraction.

4. Appareil selon la revendication 3, caractérisé en ce que la gouttière (8) est liée au cabochon (2), et qu'à leur jonction est disposé un moyen d'encliquetage (11) de l'étui (2,8) dans l'appareil (1).

5. Appareil selon l'une des revendications précédentes, caractérisé en ce que l'extraction du microphone (3) actionne un moyen de mise en circuit des éléments électroniques qui reçoivent les signaux électriques du microphone (3), ce moyen comportant notamment un relais ou un micro-contact.

6. Appareil selon l'une des revendications précédentes, caractérisé en ce qu'il comporte un moyen moteur de la sortie du microphone (3) commandé par un moyen d'escamotage de l'encliquetage (11) actionné par l'utilisateur.

0107592

1/1

FIG_1

FIG_2

FIG_3